# EUROPÄISCHE PATENTSCHRIFT

(11) **EP 0 838 088 B1**
(45) Veröffentlichungstag und Bekanntmachung des Hinweises auf die Patenterteilung: **31.10.2001**
(21) Anmeldenummer: 96921893.2
(22) Anmeldetag: 04.07.1996
(51) Int. Cl.: H01L 21/8238, H01L 27/092, H01L 29/423

(54) **VERFAHREN ZUR HERSTELLUNG EINER INTEGRIERTEN CMOS-SCHALTUNG**
PROCESS FOR MANUFACTURING AN INTEGRATED CMOS CIRCUIT
PROCEDE DE FABRICATION D'UN CIRCUIT INTEGRE CMOS

(30) Priorität: 10.07.1995 DE 19525069
(43) Veröffentlichungstag der Anmeldung: 29.04.1998
(73) Patentinhaber: Infineon Technologies AG, 81669 München (DE)
(72) Erfinder: SCHWALKE, Udo, D-84431 Heldenstein (DE); KERBER, Martin, D-81827 München (DE)
(74) Vertreter: Zedlitz, Peter, Dipl.-Inf.
(86) Internationale Anmeldenummer: DE9601202
(87) Internationale Veröffentlichungsnummer: WO9703462

(56) Entgegenhaltungen:
- EP-A- 0 337 481
- EP-A- 0 660 394
- PATENT ABSTRACTS OF JAPAN vol. 96, no. 6, 28.Juni 1996 & JP,A,08 031947 (RICOH CO LTD), 2.Februar 1996,
- PATENT ABSTRACTS OF JAPAN vol. 96, no. 3, 29.März 1996 & JP,A,07 302844 (RICOH CO LTD), 14.November 1995, & DATABASE WPI Derwent Publications Ltd., London, GB; AN 96-027838 & JP,A,07 302 844
- IEDM 88, 1988, Seiten 238-241, XP000195608 C. Y WONG ET AL: "Doping of N(-) and P(+) polysilicon in a dual-gate CMOS process" in der Anmeldung erwähnt

## Beschreibung

In CMOS-Logikschaltungen, zum Beispiel in Invertern, werden sowohl n-Kanal-MOS-Transistoren als auch p-Kanal-MOS-Transistoren eingesetzt. Elektrische Verbindungen zwischen Gateelektroden von p-Kanal-MOS-Transitoren und n-Kanal-MOS-Transistoren werden dabei vielfach in einer Gateebene realisiert, die durch Strukturierung einer Schicht gebildet wird und die neben den Gateelektroden Verbindungselemente zwischen den Gateelektroden umfaßt. Vielfach sind die Gateelektroden und die Verbindungselemente zwischen den Gateelektroden als durchgehende Gateleitung realisiert. In CMOS-Schaltungen, die mit einer Versorgungsspannung von 5 Volt betrieben werden, wird die Gateebene meist aus n⁺-dotiertem Polysilizium oder Polyzid realisiert.

In CMOS-Schaltungen für Low-Voltage/Low-Power-Anwendungen, die mit einer Versorgungsspannung von < 3 Volt betrieben werden, werden die MOS-Transistoren so optimiert, daß sie Einsatzspannungen |Vₜₕ| < 0,5 Volt bei gleichzeitig niedrigen Leckströmen aufweisen. Die damit verbundenen hohen Anforderungen an das Kurzkanalverhalten der MOS-Transistoren werden durch Einsatz einer Dual-Workfunction-Gate-Technologie mit optimierter Gateaustrittsarbeit erfüllt. Unter Dual-Workfunction-Gate-Technologie wird die Tatsache verstanden, daß die Gateelektrode der n-Kanal-MOS-Transistoren n⁺-dotiert und die Gateelektrode der p-Kanal-MOS-Transistoren p⁺-dotiert ist. Wegen dieser unterschiedlichen Dotierung in den Gateelektroden für die n-Kanal-MOS-Transistoren und die p-Kanal-MOS-Transistoren besteht bei einer Gateebene mit durchgehender Gateleitung, die unterschiedlich dotierte Gateelektroden verbindet, die Gefahr einer lateralen Dotierstoffdiffusion (siehe zum Beispiel L. C. Parrillo, IEDM '85, p 398).

Die elektrischen Eigenschaften, zum Beispiel die Schwellenspannung Vₜₕ, der MOS-Transistoren hängen im wesentlichen von der Gatedotierung ab. Eine laterale Dotierstoffdiffusion führt zu einer Veränderung der Gatedotierung und damit zu unerwünschten, nicht beherrschbaren Parameterverschiebungen. Im Extremfall kann es dabei zur Umdotierung der Gateelektroden und damit zum Totalausfall der Bauelemente kommen. Ferner müssen in der Verbindung zwischen n⁺-dotierten Gateelektroden und p⁺-dotierten Gateelektroden im Hinblick auf einen niedrigen Bahnwiderstand n⁺-dotierte Gebiete und p⁺-dotierte Gebiete unmittelbar aneinander angrenzen, da sich andernfalls eine Raumladungszone ausbildet.

Zur Unterdrückung der lateralen Dotierstoffdiffusion in der Dual-Workfunction-Gate-Technologie ist vorgeschlagen worden (siehe zum Beispiel D. C. H. Yu et al, Int. J. High Speed Electronics and Systems, Vol. 5, p 135, 1994), in der Gateebene keine durchgehenden Verbindungen aus Polysilizium zwischen unterschiedlich dotierten Gateelektroden einzusetzen. Stattdessen wird die Gateleitung aus Polysilizium aufgetrennt und über eine Metallbrücke zum Beispiel aus Aluminium elektrisch leitend verbunden. Alternativ wird nach dem Auftrennen der Gateleitung ein geeigneter metallischer Leiter (TiN, W, WSi₂) abgeschieden und strukturiert. Diese Lösung ist aufwendig und erfordert zum Teil zusätzlichen Platzbedarf für Kontaktierung und Metallisierung.

Ferner wurde vorgeschlagen (siehe C. Y. Wong et al, IEDM '88, p 238), in der Dual-Workfunction-Gate-Technologie flache Source-/Drain-Gebiete und die entsprechend dotierten Gateelektroden durch Implantation mit dem selben Dotierstoff herzustellen. Dazu werden die Implantationen von der Strukturierung der Gateelektroden durchgeführt. Im Hinblick auf flache Source-/Drain-Gebiete müssen dabei Beschränkungen bei den Implantationsdosen und der thermischen Belastung beachtet werden. Dieses führt jedoch zu einem engen Prozeßfenster, zum Beispiel bei der Dotierstoffaktivierung in der Gateelektrode und Leim Planarisierungs-Reflow.

Der Erfindung liegt das Problem zugrunde, ein verbessertes Verfahren zur Herstellung einer integrierten CMOS-Schaltung in Dual-Workfunction-Gate-Technologie anzugeben, bei dem die laterale Dotierstoffdiffusion unterdrückt wird und das mit gegenüber den bekannten Lösungen verringertem Prozeßaufwand durchführbar ist.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird zur Bildung der Gateebene eine Polysiliziumschicht mit einer solchen Korngröße erzeugt, daß der mittlere Korndurchmesser in der Polysiliziumschicht größer ist, als die minimale Ausdehnung in der Gateebene. Die Erfindung macht sich die Erkenntnis zunutze, daß die laterale Dotierstoffdiffusion in der Gateebene hauptsächlich durch Korngrenzendiffusion in dem polykristallinen Silizium verursacht wird. Diese Korngrenzendiffusion ist extrem schnell. Die Bordiffusion in monokristallinem Silizium ist zum Beispiel um einen Faktor 100 bis 1000 geringer als entlang den Siliziumkorngrenzen in polykristallinem Silizium.

Durch Verwendung einer Polysiliziumschicht mit einem mittleren Korndurchmesser größer als die minimalen Abmessungen in der Gateebene wird in dem erfindungsgemäßen Verfahren die Korngrenzendichte im Bereich der minimalen Abmessungen in der Polysiliziumschicht drastisch vermindert. In diesem Bereich erfolgt die Diffusion nur in den Siliziumkörnern mit einer Diffusionsgeschwindigkeit ähnlich der in monokristallinem Silizium. Vorzugsweise wird die Polysiliziumschicht durch Abscheidung einer amorphen Siliziumschicht und anschließende solid phase crystallization, wie dies zum Beispiel aus S. Takenaka et al, SSDM '90, p 955, bekannt ist, hergestellt. Die minimale Abmessung kann zum Beispiel die Stegbreite der Verbindung zwischen zwei Gateelektroden sein.

Eine weitere Verbesserung in bezug auf die Unterdrückung der lateralen. Dotierstoffdiffusion wird durch eine Designmaßnahme in der Gateebene erzielt. Bei der Strukturierung der Polysiliziumschicht wird in der Verbindung zwischen Gateelektroden von n-Kanal- bzw. p-Kanal-MOS-Transistoren eine Engstelle geschaffen. Die Weite der Verbindung im Bereich der Engstelle ist geringer als außerhalb davon und kleiner als der mittlere Korndurchmesser der Polysiliziumschicht. Die Engstelle liegt vorzugsweise in dem Bereich, in dem n⁺-dotiertes Polysilizium an p⁺-dotiertes Polysilizium angrenzt.

In der Erfindung wird ausgenutzt, daß die Diffusion in den Siliziumkörnern entsprechend der Diffusion in monokristallinem Silizium erfolgt und damit im Vergleich zu der Diffusion über Korngrenzen um Größenordnungen reduziert ist. Da die mittlere Korngröße der Polysiliziumschicht größer ist als die kleinste Abmessung in der Gateebene, kann an dieser Stelle der kleinsten Abmessung die Diffusion nur in den Siliziumkörnern erfolgen, da hier keine Korngrenze vorhanden ist.

Die integrierte CMOS-Schaltung wird vorzugsweise in einem Halbleitersubstrat realisiert, das mindestens im Bereich der CMOS-Schaltung monokristallines Silizium umfaßt. Das Halbleitersubstrat kann dabei sowohl eine monokristalline Siliziumscheibe als auch eine monokristalline Siliziumschicht eines SOI-Substrates sein.

In dem Halbleitersubstrat werden Isolationsstrukturen zur Definition der aktiven Gebiete für den n-Kanal-MOS-Transistor und den p-Kanal-MOS-Transistor gebildet. Diese Isolationsstrukturen werden im Hinblick auf gängige Logikprozesse in einem LOCOS-Verfahren gebildet. Die Isolationsstrukturen können jedoch auch auf andere Weise gebildet werden, zum Beispiel durch einen mit isolierendem Material gefüllten Graben.

Es liegt im Rahmen der Erfindung, in dem aktiven Gebiet zur Aufnahme des n-Kanal-MOS-Transistors eine p-dotierte Wanne und in dem aktiven Gebiet zur Aufnahme des p-Kanal-MOS-Transistors eine n-dotierte Wanne zu erzeugen.

Im folgenden wird die Erfindung anhand der Figuren und eines Ausführungsbeispiels näher erläutert.
- Figur 1: zeigt ein Substrat mit Isolationsstrukturen zur Definition von aktiven Gebieten für einen n-Kanal-MOS-Transistor und einen p-Kanal-MOS-Transistor nach der Bildung von entsprechend dotierten Wannen.
- Figur 2: zeigt das Substrat nach Bildung eines Gateoxids und Abscheidung einer amorphen Siliziumschicht.
- Figur 3: zeigt das Substrat nach Bildung einer Polysiliziumschicht durch Kristallisation der amorphen Siliziumschicht.
- Figur 4: zeigt eine Aufsicht auf das Substrat nach der Bildung einer Gateebene durch Strukturierung der Polysiliziumschicht. Mit V-V, VI-VI, VII-VII, IX-IX, XI-XI ist der in Figur 5, 6, 7, 9 bzw. 11 dargestellte Schnitt durch das Halbleitersubstrat bezeichnet. Mit VIII-VIII, X-X und XII-XII ist der in den Figuren 8, 10 bzw. 12 dargestellte Schnitt bezeichnet.
- Figur 5: zeigt einen Schnitt durch das Halbleitersubstrat nach der Strukturierung der Polysiliziumschicht und des Gateoxids.
- Figur 6: zeigt den Schnitt durch das Halbleitersubstrat nach Bildung von Spacern und einer Reoxidation.
- Figur 7 und Figur 8: zeigen zueinander senkrechte Schnitte durch das Halbleitersubstrat nach einer p-Ionenimplantation.
- Figur 9 und Figur 10: zeigen zueinander senkrechte Schnitte durch das Halbleitersubstrat nach einer n-Ionenimplantation.
- Figur 11 und Figur 12: zeigen zueinander senkrechte Schnitte durch das Halbleitersubstrat nach Fertigstellung eines n-Kanal-MOS-Transistors und eines p-Kanal-MOS-Transistors.

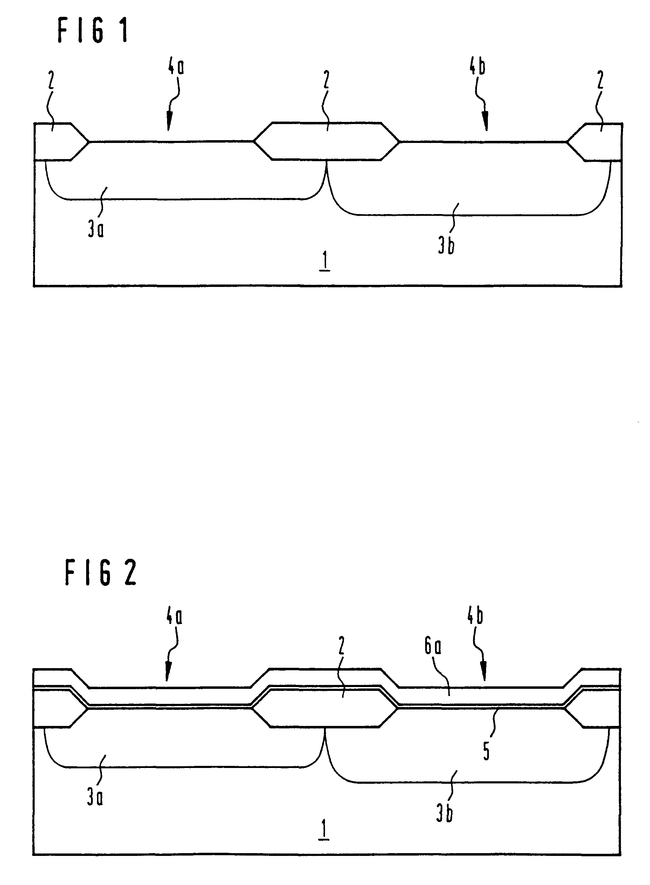

In einem Substrat 1 aus zum Beispiel monokristallinem Silizium werden zum Beispiel in einem LOCOS-Verfahren Feldoxidbereiche 2 erzeugt, die ein aktives Gebiet 4a für einen p-Kanal-MOS-Transistor und ein aktives Gebiet 4b für einen n-Kanal-MOS-Transistor definieren (siehe Figur 1). In dem aktiven Gebiet 4a für den p-Kanal-MOS-Transistor wird eine n-dotierte Wanne 3a erzeugt. In dem aktiven Gebiet 4b für den n-Kanal-MOS-Transistor wird eine p-dotierte Wanne 3b erzeugt. Die Feldoxidbereiche 2 und die Wannen 3a, 3b werden nach in der CMOS-Technologie üblichen Prozeßschritten erzeugt. In der n-dotierten Wanne 3a wird eine Dotierstoffkonzentration von zum Beispiel 1 x 10¹⁷ P/cm³, in der p-dotierten Wanne 3b eine Dotierstoffkonzentration von zum Beispiel 1 x 10¹⁷ B/cm³ eingestellt.

Durch thermische Oxidation bei zum Beispiel 900°C wird ein Gateoxid 5 in einer Dicke von zum Beispiel 3 bis 10 nm aufgewachsen (siehe Figur 2). Anschließend wird eine amorphe Siliziumschicht 6a ganzflächig abgeschieden. Die amorphe Siliziumschicht 6a wird zum Beispiel in einer Niedertemperaturabscheidung bei einer Temperatur unter 500°C, vorzugsweise im Bereich von 0.1 - 10 Torr mit Disilan (Si₂H₆) abgeschieden. Dieser Niedertemperaturabscheidungsprozeß hat im Vergleich zu einem SiH₄-Prozeß den Vorteil, daß die amorphe Siliziumschicht 6a ein verbessertes Kristallisationsverhalten zeigt. Die amorphe Siliziumschicht 6a wird undotiert oder gering dotiert mit einer Dotierstoffkonzentration unter 5 x 10¹⁹ cm⁻³ in einer Schichtdicke von 50 bis 500 nm erzeugt.

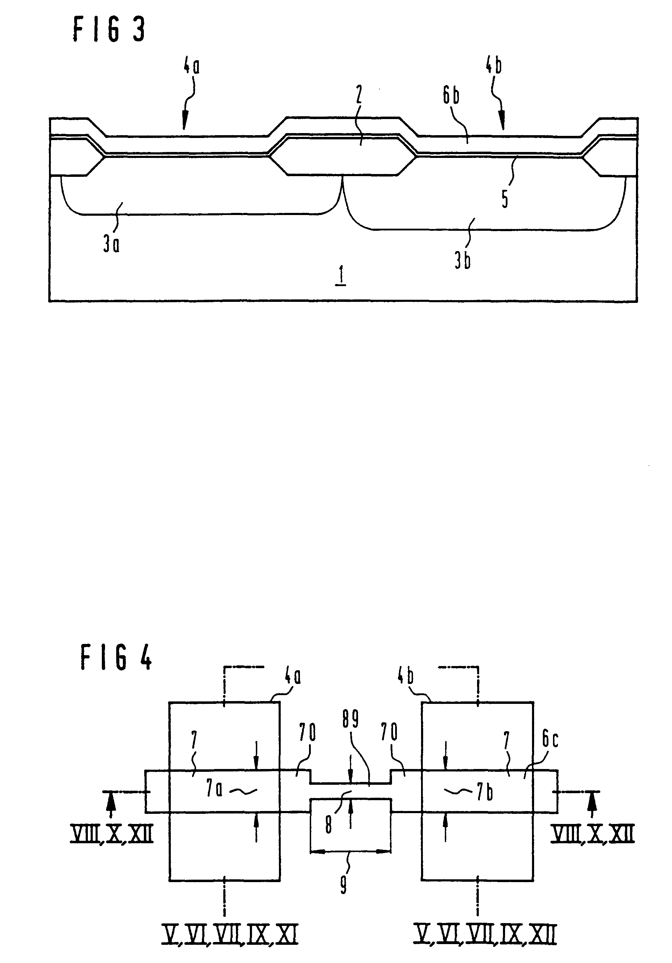

Anschließend wird die amorphe Siliziumschicht 6a durch eine Kristallisation bei niedriger Temperatur, vorzugsweise zwischen 600 und 800°C) in eine Polysiliziumschicht 6b umgewandelt (siehe Figur 3). Die polykristalline Siliziumschicht 6b besteht aus großkörnigem Polysilizium mit einer mittleren Korngröße <L> vorzugsweise > 200 nm. Die mittlere Korngröße <L> läßt sich über die Temperbedingungen, das heißt Temperatur und Dauer der Kristallisation einstellen. Bei folgenden Temperbedingungen 600°C, 8 Stunden kann eine mittlere Korngröße von mehreren um erzielt werden. Die Polysiliziumschicht 6b wird mit Hilfe einer photolithographisch erzeugten Maske und einer Ätztechnik, zum Beispiel durch anisotropes Ätzen mit HBr/Cl₂- Gas, strukturiert. Dabei wird eine Gateebene 6c gebildet, die neben undotierten Gateelektroden 7 für den p-Kanal-MOS-Transistor und den n-Kanal-MOS-Transistor eine Verbindung 70 zwischen den beiden Gateelektroden 7 umfaßt. Die Verbindung 70 umfaßt eine Engstelle 89, an der die Weite der Verbindung 70 reduziert ist. Im Bereich der Engstelle 89 beträgt die Weite 8 zum Beispiel 250 nm, außerhalb der Engstelle 89 entspricht die Weite der Verbindung 70 der Weite 7a, 7b der Gateelektroden 7, die gleich der Gatelänge des p-KanalMOS-Transistors bzw. des n-Kanal-MOS-Transistors ist (siehe Figur 4).

Die Breite 8 der Engstelle 89 wird kleiner, vorzugsweise wesentlich kleiner, als die mittlere Korngröße <L> eingestellt. Die Länge 9 der Engstelle 89 wird dagegen größer als die mittlere Korngröße <L> des Polysiliziums eingestellt. Auf diese Weise wird sichergestellt, daß im Bereich der Engstelle 89 eine laterale Dotierstoffdiffusion praktisch nur in den Siliziumkörnern erfolgt. Die Breite 8 und die Länge 9 der Engstelle 89 wird in Abhängigkeit der Polysiliziumkorngröße, dem thermischen Budget sowie von Design- und Lithographierandbedingungen eingestellt. Bei einer mittleren Korngröße <L> von zum Beispiel 400 nm beträgt die Weite 8 zum Beispiel 250 nm, die Länge 9 800 nm und die Gatelänge 7a, 7b zum Beispiel 1 µm.

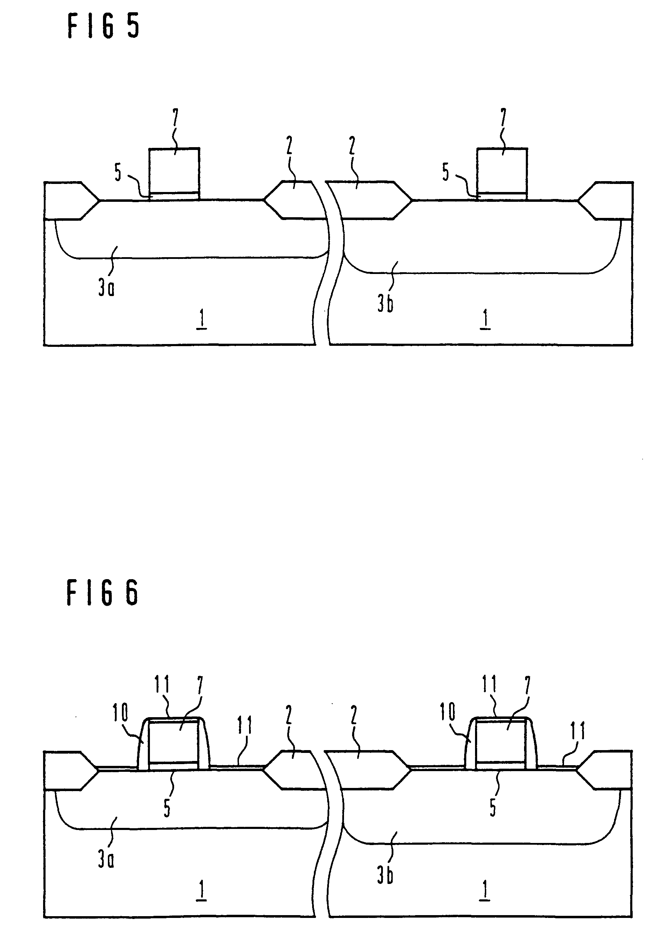

Anschließend werden an den undotierten Gateelektroden 7 durch konforme Abscheidung einer SiO₂-Schicht und anisotropes Rückätzen zum Beispiel mit CHF₃/Ar der SiO₂-Schicht mit SiO₂-Spacern 10 versehen. Durch eine thermische Oxidation zum Beispiel bei 900°C wird auf freiliegende Siliziumoberflächen eine thermische Oxidschicht 11 in einer Dicke von 15 nm erzeugt (siehe Figur 6).

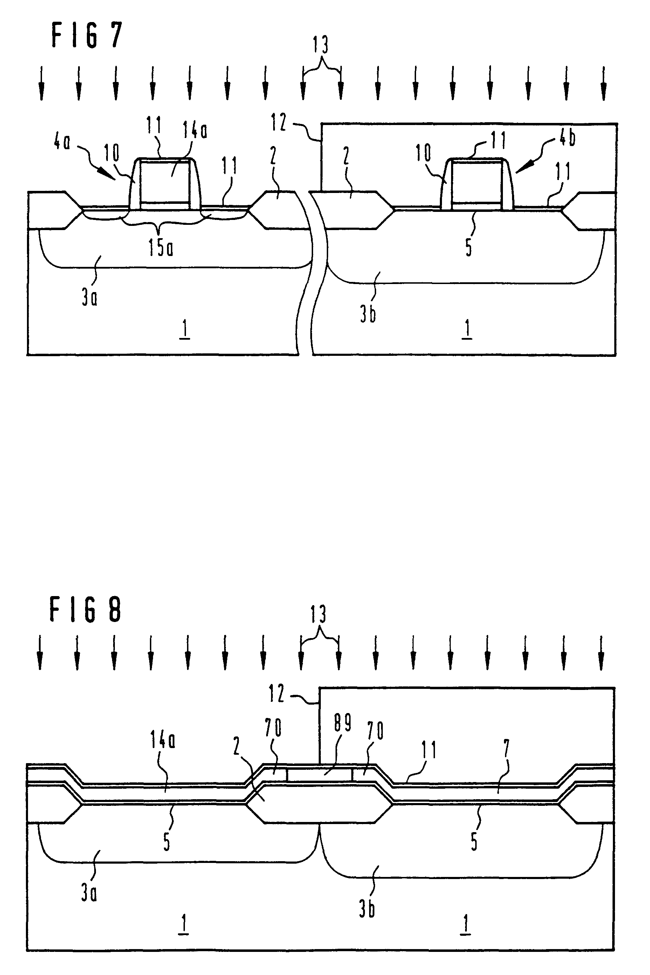

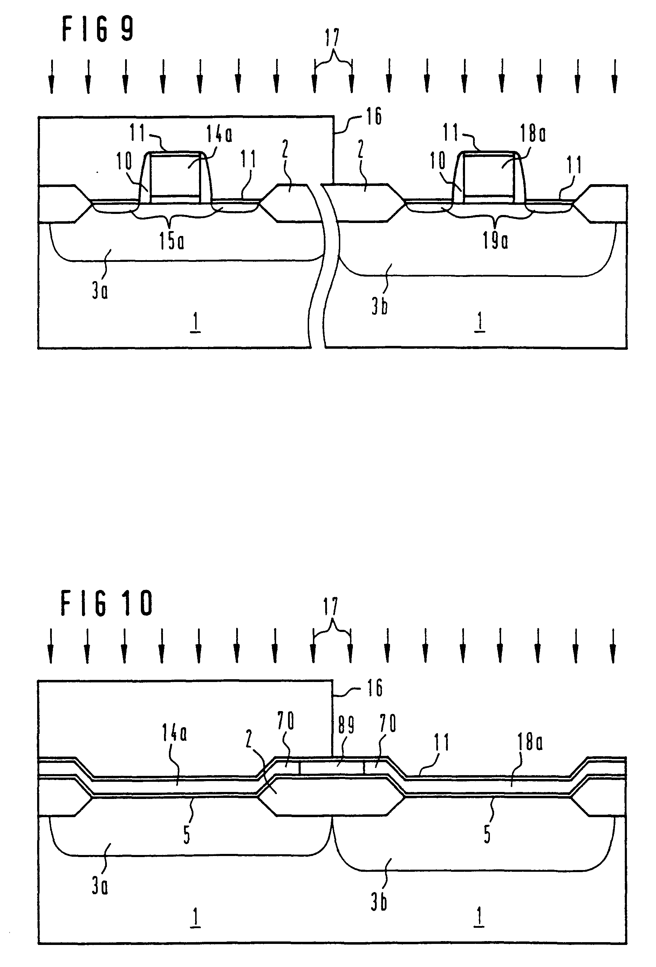

Anschließend wird mit Hilfe photolithographischer Prozeßschritte eine Photolackmaske 12 erzeugt, die das aktive Gebiet 4b für den n-Kanal-MOS-Transistor abdeckt (siehe Figur 7). Die Photolackmaske 12 reicht dabei bis auf die benachbarten Feldoxidbereiche 2. Die Photolackmaske 12 reicht bis in den Bereich der Engstelle 89 (siehe Figur 8). Durch eine Ionenimplantation 13 mit Bor oder BF₂ mit einer Dosis von zum Beispiel 5 x 10¹⁵ at/cm² und einer Energie von zum Beispiel 15 bzw. 40 keV werden eine p⁺-dotierte Gateelektrode 14 sowie p-dotierte Source/Drain-Gebiete 15a für den p-Kanal-MOS-Transistor erzeugt. Gleichzeitig wird der von der Photolackmaske 12 unbedeckte Teil der Verbindung 70 p⁺-dotiert.

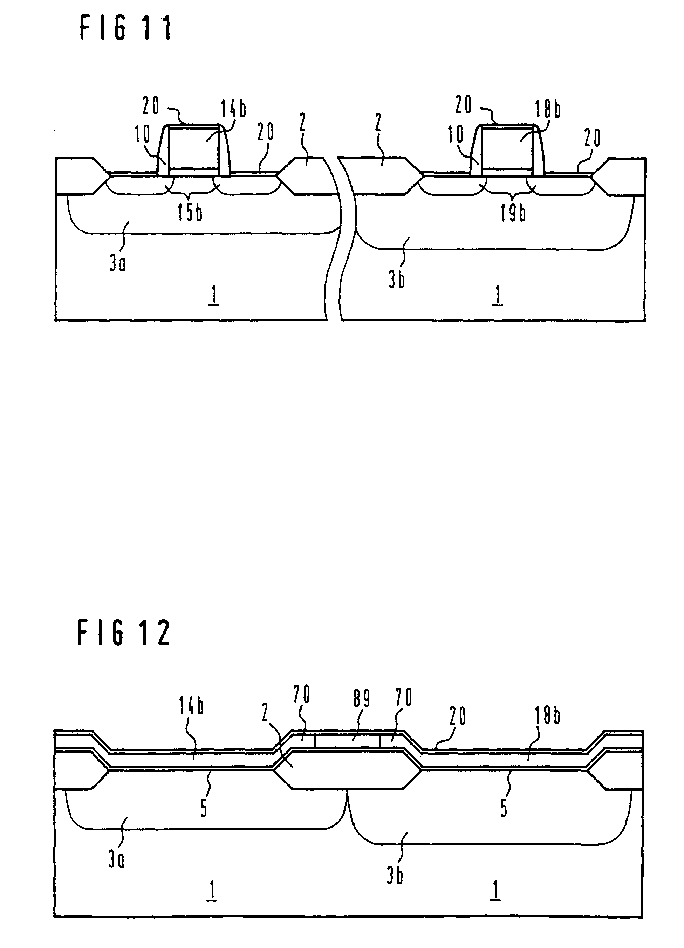

Nach Entfernen der Lackmaske 12 wird eine Photolackmaske 16 erzeugt, die das Gebiet für den p-Kanal-MOS-Transistor abdeckt (siehe Figur 9). Die Photolackmaske 16 reicht im Bereich der Verbindung 70 bis auf die Engstelle 89 (siehe Figur 10). Durch eine Implantation 17 mit Arsen oder Phosphor mit einer Dosis von 5 x 10¹⁵ at/cm² und einer Energie von 60 bzw. 120 keV werden eine n⁺-dotierte Gateelektrode 18a sowie n-dotierte Source/Drain-Gebiete 19a gebildet. Bei der Implantation 17 wird der von der Photolackmaske 16 unbedeckte Teil der Verbindung 70 und der Engstelle 89 n⁺-dotiert.

Anschließend wird die Photolackmaske 16 entfernt.

Durch Tempern des Substrats 1 wird der implantierte Dotierstoff elektrisch aktiviert. Dabei bilden sich p-dotierte Source/Drain-Diffusionsgebiete 15b und n-dotierte Source/Drain-Diffusionsgebiete 19b aus.

Ferner entstehen ein p-dotiertes Gate 14b für den p-Kanal-MOS-Transistor und ein n-dotiertes Gate 18b für den n-Kanal-MOS-Transistor (siehe Figur 11 und Figur 12).

Die thermische SiO₂-Schicht 11 wird naßchemisch, zum Beispiel mit HF/HNO₃ entfernt. Anschließend wird auf freiliegenden Siliziumflächen, das heißt auf der Oberfläche der n- bzw. p-dotierten Source/Drain-Diffusionsgebiete 15b, 19b und auf dem n- bzw. p-dotierten Gate 18b, 14b selektiv ein metallischer Leiter 20 aufgebracht. Der metallische Leiter 20 kann zum Beispiel in einem Salicide-Verfahren aus TiSi₂ gebildet werden. Der metallische Leiter 20 kann ferner durch selektive Abscheidung von Wolfram in einem CVD-Verfahren aufgebracht werden. Der metallische Leiter 20 erstreckt sich auch über die Verbindung 70 mit der Engstelle 89. Im Bereich der Engstelle 89 grenzen n⁺-dotierte und p⁺-dotierte Bereiche der Verbindung 70 aneinander. Der metallische Leiter 20 verläuft über diese Grenze und verbindet die n⁺-dotierten Bereiche der Verbindung 70 mit den p⁺-dotierten Bereichen.

Wegen der Korngröße der Polysiliziumschicht kommt es beim Tempern zum Aktivieren des Dotierstoffes im Bereich der Engstelle 89 zu keiner nennenswerten lateralen Diffusion. Im Bereich der Engstelle 89 bleibt eine scharfe Grenze zwischen n⁺-dotiertem und p⁺-dotiertem Bereich der Verbindung 70 erhalten.

Das p⁺-dotierte Gate 14b ist mit dem n⁺-dotierten Gate 18b verbunden. Die Struktur stellt einen Inverter dar.

Durch Abscheidung einer Borphosphorsilikatglasschicht und Planarisierung, sowie durch Kontaktlochätzung und Metallisierung wird die Schaltungsanordnung fertiggstellt (nicht im einzelnen dargestellt).

## Patentansprüche

1. Verfahren zur Herstellung einer integrierten CMOS-Schaltung,
- bei dem in einem Halbleitersubstrat (1) Isolationsstrukturen (2), die jeweils aktive Gebiete (4a, 4b) für mindestens einen n-Kanal-MOS-Transisstor und für mindestens einen p-Kanal-MOS-Transistor definieren, erzeugt werden,
- bei dem n-dotierte Source/Drain-Gebiete für den n-Kanal-MOS-Transistor und p-dotierte Source/Drain-Gebiete für den p-Kanal-MOS-Transistor gebildet werden,
- bei dem ein Gateoxid gebildet wird,
- bei dem ganzflächig eine Polysiliziumschicht (6b) erzeugt wird,
- bei dem durch Strukturierung der Polysiliziumschicht (6b) eine Gateebene (6c) gebildet wird, die mindestens eine Gateelektrode (7) für den n-Kanal-MOS-Transistor, eine Gateelektrode (7) für den p-Kanal-MOS-Transistor und eine Verbindung (70) zwischen den Gateelektroden (7) umfaßt,
- bei dem die Polysiliziumschicht (6b) mit einer solchen Korngröße erzeugt wird, daß der mittlere Korndurchmesser größer ist als die minimale Ausdehnung (89) der strukturierten Polysiliziumschicht in der Gateebene (6c),
- bei dem die Gateelektrode (18a) für den n-Kanal-MOS-Transistor n-dotiert und die Gateelektrode (14a) für den p-Kanal-Transistor p-dotiert wird,
- bei dem mindestens die Oberfläche der Gateebene (6c) mit einem metallischen Leiter (20) versehen wird.

2. Verfahren nach Anspruch 1,
bei dem zur Bildung der Polysilziumschicht (6b) eine amorphe Siliziumschicht (6a) abgeschieden wird, aus der durch Kristallisation in einem Temperschritt die Polysiliziumschicht (6b) gebildet wird.

3. Verfahren nach Anspruch 2,
- bei dem die amorphe Siliziumschicht (6a) unter Verwendung von Si₂H₆ als Prozeßgas im Temperaturbereich zwischen 400°C und 500°C abgeschieden wird,
- bei dem der Temperschritt zur Kristallisation im Temperaturbereich zwischen 600 und 800°C durchgeführt wird.

4. Verfahren nach einem der Ansprüche 1 bis 3,
bei dem die Verbindung (70) zwischen den Gateelektroden (7) eine Engstelle (89) aufweist, an der die Ausdehnung der Verbindung (70) geringer ist als außerhalb der Engstelle (89).

5. Verfahren nach einem der Ansprüche 1 bis 4,
- bei dem die Dotierung der Gateelektrode (18a) für den n-Kanal-MOS-Transistor durch Implantation mit n-dotierenden Ionen erfolgt, wobei gleichzeitig die n-dotierten Source/Drain-Gebiete (19a) gebildet werden,
- bei dem die Dotierung der Gateelektrode für den p-Kanal-MOS-Transistor durch eine Implantation mit p-dotierenden Ionen erfolgt, wobei gleichzeitig die p-dotierten Source/Drain-Gebiete (15a) gebildet werden.

6. Verfahren nach einem der Ansprüche 1 bis 5,
bei dem die Isolationsstrukturen (2) in einem LOCOS-Verfahren gebildet werden.

7. Verfahren nach einem der Ansprüche 1 bis 6,
bei dem in dem aktiven Gebiet zur Aufnahme der n-Kanal-MOS-Transistoren eine p-dotierte Wanne (3b) und in dem aktiven Gebiet zur Aufnahme der p-Kanal-MOS-Transistoren eine n-dotierte Wanne (3a) erzeugt werden.

## Claims

1. Method for the production of an integrated CMOS circuit,
- in which insulation structures (2), which each define active regions (4a, 4b) for at least one n-channel MOS transistor and for at least one p-channel MOS transistor, are produced in a semiconductor substrate (1),
- in which n-doped source/drain regions are formed for the n-channel MOS transistor and p-doped source/drain regions are formed for the p-channel MOS transistor,
- in which a gate oxide is formed,
- in which a polysilicon layer (6b) is produced over the whole area,
- in which a gate plane (6c), which comprises at least a gate electrode (7) for the n-channel MOS transistor, a gate electrode (7) for the p-channel MOS transistor and a connection (70) between the gate electrodes (7), is formed by structuring the polysilicon layer (6b),
- in which the polysilicon layer (6b) is produced with a grain size such that the average grain diameter is greater than the minimum extent (89) of the structured polysilicon layer in the gate plane (6c),
- in which the gate electrode (18a) for the n-channel MOS transistor is n-doped and the gate electrode (14a) for the p-channel MOS transistor is p-doped,
- in which at least the surface of the gate plane (6c) is provided with a metallic conductor (20).

2. Method according to Claim 1,
in which an amorphous silicon layer (6a) is deposited for the purpose of forming the polysilicon layer (6b), the polysilicon layer (6b) being formed from said silicon layer by crystallization in a heat-treatment step.

3. Method according to Claim 2,
- in which the amorphous silicon layer (6a) is deposited using Si₂H₆ as process gas in the temperature range between 400°C and 500°C,
- in which the heat-treatment step for crystallization is carried out in the temperature range between 600 and 800°C.

4. Method according to one of Claims 1 to 3,
in which the connection (70) between the gate electrodes (7) has a constriction (89) at which the extent of the connection (70) is smaller than outside the constriction (89).

5. Method according to one of Claims 1 to 4,
- in which the doping of the gate electrode (18a) for the n-channel MOS transistor is effected by implantation with n-doping ions, the n-doped source/drain regions (19a) being formed simultaneously,
- in which the doping of the gate electrode for the p-channel MOS transistor is effected by implantation with p-doping ions, the p-doped source/drain regions (15a) being formed simultaneously.

6. Method according to one of Claims 1 to 5,
in which the insulation structures (2) are formed using a LOCOS method.

7. Method according to one of Claims 1 to 6,
in which a p-doped well (3b) is produced in the active region for accommodating the n-channel MOS transistors and an n-doped well (3a) is produced in the active region for accommodating the p-channel MOS transistors.

## Revendications

1. Procédé de fabrication d'un circuit intégré CMOS,
- dans lequel, on produit dans un substrat (1) semiconducteur des structures (2) d'isolement, qui définissent respectivement des domaines (4a, 4b) actifs pour au moins un transistor MOS à canal n, et pour au moins un transistor MOS à canal p,
- dans lequel, on forme des domaines source/drain à dopage n, pour le transistor MOS à canal n et des domaines source/drain à dopage p, pour le transistor MOS à canal p,
- dans lequel, on forme un oxyde de grille,
- dans lequel, on produit sur toute la surface une couche (6b) de polysilicium,
- dans lequel, on forme par structuration de la couche (6b) de polysilicium un plan (6c) de grille, qui comprend au moins une électrode (7) de grille pour le transistor MOS à canal n, une électrode (7) de grille pour le transistor MOS à canal p et une liaison (70) entre les électrodes (7) de grille,
- dans lequel, on donne à la couche (6b) de polysilicium une granulométrie telle, que le diamètre moyen de grain est supérieur à l'étendue (89) minimum de la couche de polysilicium structurée dans le plan (6c) de grille,
- dans lequel, on dope d'un dopage n, l'électrode (18a) de grille pour le transistor MOS à canal n et on dope d'un dopage p l'électrode (14a) de grille, pour le transistor à canal p,
- dans lequel, on munit au moins la surface du plan (6c) de grille d'un conducteur (20) métallique.

2. Procédé suivant la revendication 1, dans lequel on dépose pour former la couche (6b) de polysilicium, une couche (6a) de silicium amorphe à partir de laquelle, on forme par cristallisation dans un stade de traitement thermique, la couche (6b) de polysilicium.

3. Procédé suivant la revendication 2,
- dans lequel on dépose la couche (6a) de silicium amorphe, en utilisant une substance Si₂H₆ comme gaz de processus, dans la plage de température comprise entre 400°C et 500°C,
- dans lequel on effectue le stade de traitement thermique, pour la cristallisation, dans la plage de température comprise entre 600 et 800°C.

4. Procédé suivant l'une des revendications 1 à 3, dans lequel la liaison (70) entre les électrodes (7) de grille, présente un point (89) étroit où l'étendue de la liaison (70) est plus petite qu'à l'extérieur du point (89) étroit.

5. Procédé suivant l'une des revendications 1 à 4,
- dans lequel on effectue le dopage de l'électrode (18a) de grille pour le transistor MOS à canal n, par implantation d'ions à dopage n, en formant en même temps les domaines (19a) source/drain à dopage n,
- dans lequel on effectue le dopage de l'électrode de grille pour le transistor MOS à canal p, par une implantation par des ions à dopage p, en formant en même temps les domaines (15a) source/drain à dopage p.

6. Procédé suivant l'une des revendications 1 à 5, dans lequel on forme les structures (2) d'isolation dans un procédé LOCOS.

7. Procédé suivant l'une des revendications 1 à 6, dans lequel on produit dans le domaine actif, en vue de la réception des transistors MOS à canal n, une cuvette (3b) à dopage p et dans la zone active pour la réception des transistors MOOS à canal p, une cuvette (3a) à dopage n.
